# EUROPEAN PATENT SPECIFICATION

(11) **EP 1 514 127 B1**
(45) Date of publication and mention of the grant of the patent: **29.09.2010**
(21) Application number: 03727260.6
(22) Date of filing: 14.05.2003
(51) Int. Cl.: G01R 33/30

(54) **PROBEHEAD FOR NMR SPECTROMETER**
PROBENKOPF FÜR NMR-SPEKTROMETER
TETE DE SONDE POUR SPECTROMETRE A RESONANCE MAGNETIQUE NUCLEAIRE

(30) Priority: 30.05.2002 EE 200200025 U
(43) Date of publication of application: 16.03.2005
(73) Proprietor: KEEMILISE JA BIOLOOGILISE FÜÜSIKA INSTITUUT, EE12618 Tallinn (EE)
(72) Inventor: SAMOSON, Ago, EE12617 Tallinn (EE); TUHERM, Tiit, EE12613 Tallinn (EE); PAST, Jaan, EE13411 Tallinn (EE); REINHOLD, Andres, EE12617 Tallinn (EE); ANUPOLD, Tiit, EE13420 Tallinn (EE)
(74) Representative: Pikkor, Riho
(86) International application number: PCT/EE2003/000002
(87) International publication number: WO 2003/102615

(56) References cited:
- EP-A- 0 020 085
- WO-A-92/15023
- US-A- 4 254 373
- M. W. BORER, S.R. MAPLE: "Control of Spinning Sidebands in High Resolution NMR Spectroscopy" JOURNAL OF MAGNETIC RESONANCE, APRIL 1998, ACADEMIC PRESS, USA, vol. 131, pages 177-183, XP002254719 ISSN: 1090-7807

## Description

The invention relates to radiospectroscopy and deals in particular with a probehead for nuclear magnetic resonance (NMR) measurement.

NMR is a method of radiospectroscopy for study of structural and dynamic properties of the matter. In order to narrow detected spectral lines and improve resolution, a fast mechanical rotation of the sample under a certain angle with respect of the magnetic field direction is used. A known patent of E. Lippmaa et.al. US-4254373, It C13 G01R 33/08, 1981, describes a probehead, containing a rotor with the studied sample. A radiofrequency NMR coil is wound around the rotor, leaning on bearings and equipped with one or two turbines allowing to rotate the rotor in one direction, executive unit and control unit, whereby the rotor speed is controlled by one common gas channel for the both turbines. A shortcoming of the known probehead is unefficient rotor speed control with no possibility to change the direction of rotation, limiting the content of obtained information about the sample in certain cases.

The goal of the invention is to obtain information about the sample under conditions of fast rotor velocity change and inversion of the rotation direction.

The task is solved in such a manner, that in the probehead for measuring nuclear magnetic resonance,
which probehead is comprised of a frame, a radio frequency coil attached thereto and a rotor located inside the coil containing the sample to be examined, which rotor is supported by bearings and provided with turbines at both ends, comprising a forward turbine and a counter-directed turbine, a source of compressed gas, and an executive unit and a control unit controlling rotation of said probehead,
said executive unit is provided with at least two compressed gas channels for rotor velocity and/or direction control to provide rotation in opposite direction, whereby said executive unit is arranged to
a) for rapid acceleration of the rotor, increase gas pressure in a first compressed gas channel at said forward turbine,
b) for deceleration, stop or reversal of the rotor, increase gas pressure in a second compressed gas channel at said counter-directed turbine and simultaneously reduce gas pressure to said forward turbine.

In the preferred embodiment there are two turbines at each end of the rotor and the executive unit has been provided with four velocity control compressed gas channels. Thus at each end of the rotor there's a turbine that makes the rotor rotate in one direction and another turbine that makes it rotate in the opposite direction. The increased number of turbines allows increasing the start acceleration of rotation by applying higher momentum to the rotor.

It is also preferred that the diameter of the cylindrical turbines is less than the diameter of the rotor when achieving maximum velocity in a provided direction of rotation is the relevant parameter. E.g. when the diameter of the cylindrical turbine is decreased two times, then at the same linear velocity the angular velocity doubles.

In order to achieve higher velocity and to reverse the rotor's direction of rotation the dimensions of the turbines have been brought down to the minimum. But the relatively small volume of the rotor and thus the examined example in comparison with the area of the examined sample causes a distortion of the measured signal due to the inhomogeneity of the magnetic field during passage from one environment to another when the magnetic susceptibility of the environments is different. Therefore it is preferable either to unify the susceptibility or to minimize the mass of substance with different receptiveness around the rotor.

In order to decrease signal distortion the coil is preferably connected to the inner surface of the frame with at least two, preferably four sufficiently strong thin non-conductive and non-magnetic sheets that are preferably positioned radially. The most suitable material is ceramics. In order to combine the coil and the ceramic sheet, the coil end of the ceramic sheet is provided with grooves that house coil sections.

The length and thickness ratio of the ceramic sheet is preferably 200:1 to 50:1. A higher ratio may cause the sheet to break; a lower ratio may cause the homogeneity of the magnetic field to be compromised.

Signal distortion by magnetic field inhomogeinity is reduced by minimizing bulk volume of the coil and supporting construction. The coil is supported by very thin sheets or stripes of strong, non-conductive and non-magnetic material (typically technical ceramic). The rotor velocity of the probehead can be modified and direction of the rotation changed, all this enables to obtain additional information about the investigated sample. The information is detected in a form of electromagnetic waves, picked up by a special coil. The coil is located as close as possible around the rotor, and may need mechanical support for exact and stable positioning. The coil and support are carefully selected to avoid disturbance of the magnetic field homogeneity. Novel feature of present invention is also special support construction, designed to minimize bulk susceptibility changes around the sample. The support comprises two or more thin sheets of sufficiently strong material, fixing the coil by either tangential or radial mechanical contact. Sufficiently high acceleration rates of the rotor can only be achieved for rotors of no more than few mm in diameter. Relatively small volume of the sample makes overall signal sensitive for construction features of details around the sample. Therefore, coil support presents a logical part of the whole probehead.

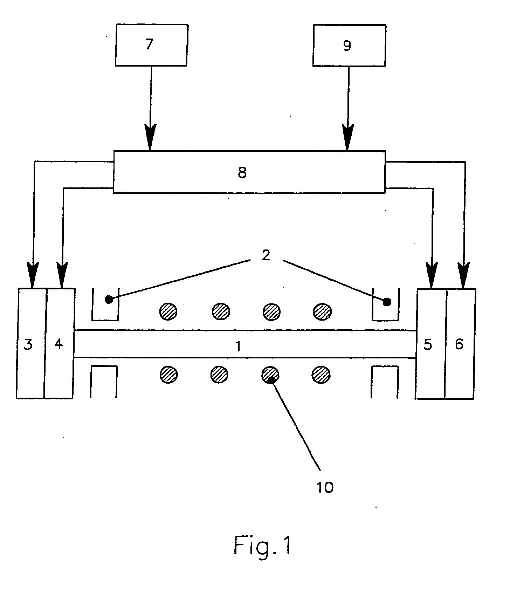

Fig. 1 presents a principal layout of our turbine probehead.

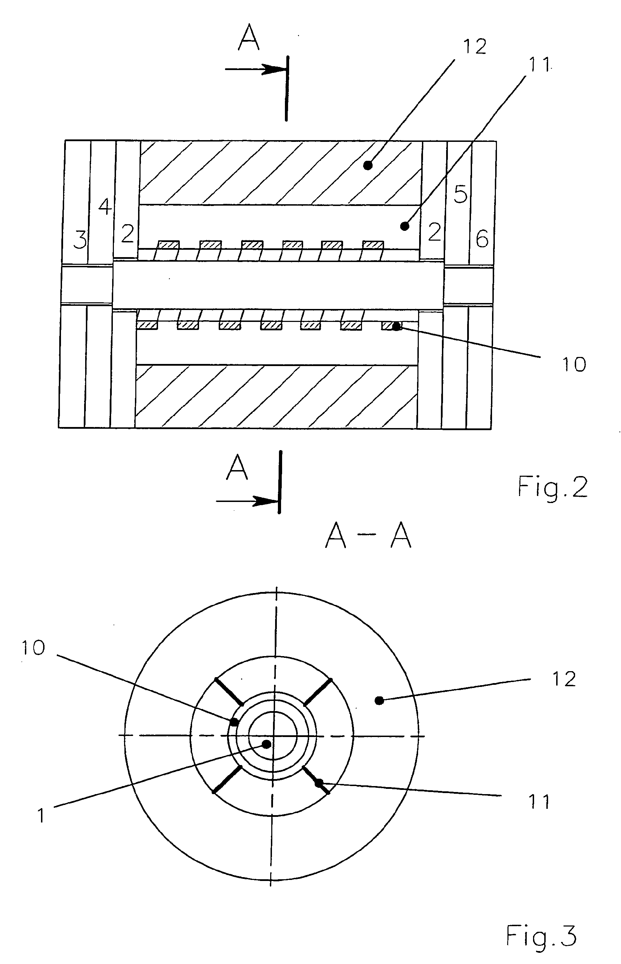

Fig. 2 presents construction for signal pickup coil support, based on radially arranged ceramic sheets.
Fig. 3 presents perpendicular view A-A from fig. 2.

NMR probehead contains investigated sample, located in the rotor 1. The rotor leans on bearings 2 and is equipped with turbines 3, 4, 5, 6. The turbines 3 and 6 generate motion, which may be reversed compared to turbines 4 and 5. In principle, only two turbines are required for realising physical idea of the experiment. Larger number of turbines may be required to achieve sufficiently high acceleration rate of the rotor, by delivering more momentum to the rotor. The source of high-pressure gas 7 is connected with turbines via execution unit 8, which is operated by a control unit 9. Coil 10 is supported by very thin ceramic sheets 11, connected to the frame 12 e.g. by glued joint. Sufficiently high acceleration rates of the rotor can only be achieved for rotors of no more than few mm in diameter. Diameter of rotor in realized embodiment is 1,8 mm and diameter of working surface of turbines is 1,6 mm.

Operation principle of the NMR probehead is following. The rotor 1 is filled with a sample to be measured. A suitable combination of the turbines is selected to activate motion. Change of the rotor speed or its reversal is accomplished by execution unit 8. The execution unit 8 comprises either valves or switches, located either in the probehead or externally, and switched typically by electromagnets. The purpose being regulation of the pressure and amount of the compressed gas, flowing from the reservoir 7 to the turbines 3-6, as determined by signal from the control unit 9. For a rapid acceleration of the rotor, execution unit will increase gas pressure at forward turbines. Deceleration, stop or reversal of the rotor motion pressure is increased at counter-directed turbines, simultaneously reducing gas flow to forward turbines.

Total number of turbines can be two (one for each direction, or both same direction, one of which to provide acceleration), but in this case the efficiency of the rotor acceleration is correspondingly reduced in comparison with four turbines version.

Described probehead is applied for modification of dipolar interaction between atoms in studied sample. This process is able to carry spectral frequency, characterizing atom A, to atom B and further to atom C, proving spatial proximity of atoms A and C. Novel feature is using auxiliary, messenger atom B for information transport. The probehead enables also significantly more extended distance of the information transport,

Very important practical application of this probehead is a possibility to determine sequence of aminoacids in peptides and proteins. Atoms A and B are alfa-carbons of the neighbouring aminoacids, auxiliary messenger atom is carbonyl carbon in between.

## Claims

1. A probehead for measuring nuclear magnetic resonance, which probehead is comprised of a frame (12), a radio frequency coil (10) attached thereto and a rotor (1) located inside the coil containing the sample to be examined, which rotor is supported by bearings (2) and is provided with turbines (3, 5) at both ends, a source of compressed gas (7), and an executive unit (8) and a control unit (9) controlling rotation of said probehead,
**characterized in that**
said turbines comprise a forward turbine (3) and a counter-directed turbine (5), and that
said executive unit (8) is provided with at least two compressed gas channels for rotor velocity and/or direction control to provide rotation in opposite direction, whereby said executive unit (8) is arranged to,
a) for rapid acceleration of the rotor (1), increase gas pressure in a first compressed gas channel at said forward turbine (3),
b) for deceleration, stop or reversal of the rotor (1), increase gas pressure in a second compressed gas channel at said counter-directed turbine (5) and simultaneously reduce gas pressure to said forward turbine (3).

2. A probehead as claimed in claim 1 **characterized in that** at both ends of the rotor (1) there are two turbines respectively (3, 4, 5, 6) and the executive unit (8) has been provided with four compressed gas channels for rotor velocity and/or direction control.

3. A probehead as claimed in claim 1 **characterized in that** the turbines (3, 4, 5, 6) are cylindrical and the diameter of their work area is less than the diameter of the rotor.

4. A probehead as claimed in claim 1 **characterized in that** the coil (10) is connected to the inner surface of the frame (12) with at least two, preferably four sheets (11) of thin non-conductive and non-magnetic material.

5. A probehead as claimed in claim 4 **characterized in that** the sheets (11) are made of ceramic material.

6. A probehead as claimed in claim 4 **characterized in that** the coil ends of the sheets (11) comprise grooves for housing coil sections.

7. A probehead as claimed in claim 4 **characterized in that** the ratio of the length and thickness of the sheets (11) is 200:1 to 50:1.

## Patentansprüche

1. Ein Probenkupf zur Messung der nuklearen Magnetresonanz, welcher aus dem Rahmen (12), der an diesem befestigten Funkfrequenzspule (10) und dem innerhalb der Spule befindlichen Rotor (1), welcher das zu untersuchende Muster enthält, besteht, der Rotor stützt sich auf Lager (2) und ist an beiden Enden mit Turbinen (3, 5), mit der Quelle des komprimierten Gases (7) und der ausführenden Einheit (8) sowie einer Kontrolleinheit (9), die die Rotation des besagten Probenkopfes kontrolliert, versehen,
**dadurch gekennzeichnet, dass**
die besagten Turbinen die Vorwärtsturbine (3) und die Gegenturbine (5) enthalten und die besagte ausführende Einheit (8) mit mindestens zwei Kanälen des komprimierten Gases für Rotorgeschwindigkeit und/oder Richtungskontrolle zur Einstellung der Rotation in entgegengesetzter Richtung versehen sind, wobei
die besagte ausführende Einheit (8) vorgesehen ist
a) zur schnellen Beschleunigung des Rotors (1), Erhöhung des Gasdruckes im ersten Kanal des komprimierten Gases an der besagten Vorwürtsturbine (3),
b) zum Abbremsen, Anhalten oder Umkehren des Rotors (1), Erhöhung des Gasdruckes im zweiten Kanal des komprimierten Gases an der besagten Gegenturbine (5) und zur gleichzeitigen Reduzierung des Gasdruckes an der besagten Vorwärtsturbine (3).

2. Ein Probenkopf nach Anspruch 1, **dadurch gekennzeichnet, dass** es an beiden Enden des Rotors (1) jeweils zwei Turbinen gibt (3, 4, 5, 6) und die ausführende Einheit (8) mit vier Kanälen des komprimierten Gases für Rotorgeschwindigkeit und/oder Richtungskontrolle versehen ist.

3. Ein Probenkopf nach Anspruch 1, **dadurch gekennzeichnet, dass** die Turbinen (3, 4, 5, 6) zylindrisch sind und der Durchmesser ihres Arbeitsbereichs unter dem Durchmesser des Rotors liegt.

4. Ein Probenkopf nach Anspruch 1, **dadurch gekennzeichnet, dass** die Spule (10) an die Innenfläche des Rahmens (12) mit mindestens zwei, vorzugsweise vier Blättern (11) eines dünnen nichtleitenden und nichtmagnetischen Materials befestigt ist.

5. Ein Probenkopf nach Anspruch 4, **dadurch gekennzeichnet, dass** die Blätter (11) aus keramischem Material gefertigt sind.

6. Ein Probenkopf nach Anspruch 4, **dadurch gekennzeichnet, dass** die Spulenenden der Blätter (11) Auskehlungen für die Einschließung der Spulensektionen enthalten.

7. Ein Probcnkopf nach Anspruch 4, **dadurch gekennzeichnet, dass** das Verhältnis der Länge und der Stärke der Blätter (11) 200:1 zu 50:1 ist.

## Revendications

1. Une tête de sonde pour mesurer la résonance magnétique nucléaire, dont la tête de sonde se compose d'un cadre (12), une bobine de radio-fréquence (10) qui y est attachée et un rotor (1) situe à l'intérieur de la bobine contenant l'échantillon à être analysé, dont le rotor est soutenu par des roulements (2) et est fourni avec des turbines (3, 5) à chaques extrémités, une source de gaz comprimé (7), et une unité d'exécution (8) et une unité de contrôle (9) contrôlant la rotation de ladite tête de sonde,
**caractérisée en ce que**
lesdites turbines comprennent une turbine avant (3) et une turbine contre-dirigée (5), et ladite unité d'exécution (8) est fournie avec au moins deux canaux de gaz comprimé pour le contrôle de la vélocité et/ou direction du rotor pour fournir une rotation dans le sens inverse, par laquelle
ladite unité d'exécution (8) est arrangée pour,
a) pour une accélération rapide du rotor (1), augmenter la pression du gaz dans un premier canal de gaz comprimé à ladite turbine avant (3),
b) pour la décélération, l'arrêt ou le renversement du rotor (1), augmenter la pression du gaz dans un second conduit de gaz comprimé à ladite turbine contre-dirigée (5) et simultanément réduire la pression du gaz à ladite turbine avant (3).

2. Une tête de sonde comme revendiquée dans la revendication 1 **caractérisée en ce que** à chaques extrémités du rotor (1) il y a deux turbines respectivement (3, 4, 5, 6) et l'unité d'exécution (8) a été fournie avec quatre canaux de gaz comprimé pour le contrôle de la vélocité et/ou direction du rotor.

3. Une tête de sonde comme revendiquée dans la revendication 1 **caractérisée en ce que** les turbines (3, 4, 5, 6) sont cylindriques et le diamètre de leur zone de travail est inférieur au diamètre du rotor.

4. Une tête de sonde comme revendiquée dans la revendication 1 **caractérisée en ce que** la bobine (10) est connectée à la surface interne du cadre (12) avec au moins deux, de préférence quatre feuilles (11) finies de matériau non-conducteur et non-magnétique.

5. Une tête de sonde comme revendiquée dans la revendication 4 **caractérisée en ce que** les feuilles (11) sont faites d'un matériau céramique.

6. Une tête de sonde comme revendiquée dans la revendication 4 **caractérisée en ce que** les extrémités vers la bobine des feuilles (11) comprennent des rainures pour encastrer des sections de la bobine.

7. Une tête de sonde comme revendiquée dans la revendication 4 **caractérisée en ce que** le ratio de la longueur et l'épaisseur des feuilles (11) est de 200:1 à 50:1.
